# EUROPEAN PATENT APPLICATION

(11) **EP 1 557 775 A1**
(43) Date of publication of application: **27.07.2005**
(21) Application number: 05100028.9
(22) Date of filing: 04.01.2005
(51) Int. Cl.: G06F 17/50

(54) **A method for placement of pipeline latches**

(30) Priority: 20.01.2004 EP 04100164
(71) Applicant: International Business Machines Corporation, Armonk, 35 10504 (US)
(72) Inventor: Arp, Andreas, 71101 Schönaich (DE); Buehler, Markus, Dr., 71065 Sindelfingen (DE); Eckert, Martin, 71131 Jettingen (DE); Pille, Jürgen, 70199 Stuttgart (DE)
(74) Representative: Teufel, Fritz

(57) **Abstract**

Method for determining placement of pipeline latches, the method comprising:
- providing data descriptive of placement of data sources and data sinks,
- in case a path length of a path connecting one of the data sources to one of the data sinks is longer than a maximum signal propagation length, placing a pipeline latch a distance from the data source, the distance being shorter than or equal to the maximum signal propagation length,
- in case a path length of a path connecting the pipeline latch to the one of the data sinks is longer than the maximum signal propagation length, placing an additional pipeline latch an additional distance from the pipeline latch, the additional distance being shorter than or equal to the maximum signal propagation length.

## Description

### Field of the invention

The present invention relates generally to the field of integrated circuit chip layout, and more particularly to computer aided design of integrated circuitry and the automated physical layout of integrated circuitry.

### Background and prior art

Microelectronic integrated circuits consist of a large number of electronic components that are fabricated by layering several different materials on a silicon base or wafer. The design of an integrated circuit transforms a circuit description into a geometric description which is known as a *layout*. The process of converting the functional specifications of an electronic circuit into a *layout* is called the physical design.

The objective of physical design is to determine an optimal arrangement of devices in a plane or in a three dimensional space, and an efficient interconnection or routing scheme between the devices to obtain the desired functionality.

An integrated circuit chip (hereafter referred to as an "IC" or a "*chip*") comprises cells and connections between the cells formed on a surface of a semiconductor substrate. The IC may include a large number of cells and require complex connections between the cells.

In order to take advantage of this technology, millions of circuits must by physically placed and connected on the chip. This can be a very time consuming process, especially when the actual process of designing, placing, and connecting the circuits on the chip can affect the performance and timing requirements of the chip. Therefore, it has become necessary to automate the design process by using a computer to quickly place and wire predesigned circuits into a functional chip.

The basic problem with this automation technique is that it sacrifices the performance of the resulting circuit for the ability to get a connected circuit in a reasonable amount of computing time. When the functional chip being designed is a central processing unit of a computer or other chip in which performance is critical and design complexity high, the performance sacrificed is not acceptable and the automation technique is not useful. This performance sacrifice usually manifests itself in the inability to obtain timing closure in complicated logic. Timing closure is the difference between the time allowed for processing information on the chip as logically designed, and the time required for processing information on the chip as physically designed. Timing closure is not met when the chip as physically wired and placed is not as fast as required by the logical design.

The sacrifice in performance from the prior art automated placement and wire techniques is in two main areas. First, the prior art techniques are mainly concerned with the length of individual wires connecting the individual circuits. It is true that minimizing length helps alleviate performance difficulties, however, the size of the individual drivers driving the lines is also a critical performance factor that is not accounted for by these techniques. Additionally, not all wire lengths need to be minimized. Selectivity in which wire lengths to minimize is critical to completing the overall design. Second, prior art techniques analyze physical placement effects on timing by computing those effects from a detailed timing model. This analysis requires significant computing time which limits the use of the timing model for all circuit placement changes.

Some solutions to the above problems include sensitizing the wiring program to critical logical nets. Critical nets are those circuits within the chip which have relatively more impact on the overall chip performance than do other nets. The sensitization of the wiring program would identify those nets and wire them near the beginning of the program so that they would avoid having to deal with later chip wire congestion and therefore have a greater chance to be as short as possible. This type of sensitization would also include a minimization of the number of maximum crossings of a reference line. The number of crossings would indicate how many bends in the wire which impede circuit performance, therefore, minimizing the number of bends would enhance the chip performance. Although this technique improves performance, it does not address the physical placement of the circuits which created the critical nets.

An alternative approach would be to do a complete timing analysis of the chip after the physical design and identify the critical areas where the physical design added significant delay to critical logical nets. When these areas are found, individual circuits can be rearranged so as to minimize the performance impact. The problem with this is that when the number of circuits gets large or the wiring channels get densely populated the individual changes are difficult and time consuming to make. Also, the number of changes to be made must be limited to reduce the complexity of individual changes and their impact on the design. These difficulties make this design alternative limited because the chips requiring automation typically have large numbers of circuits.

A further alternative design automation approach involves automatically swapping the position of circuits within a chip after it has been wired and recalculating the timing parameters. This procedure leads to inordinate computation time because it is typical to find many paths being affected by an interchange in only two circuits. Therefore, the position swapping is limited in some manner to only those critical paths, physical and logical, which are judged to involve the greatest impact on the circuit. This limitation on which circuits to interchange, limits the effectiveness of the automation procedure. This is because many physical positions of circuits are never evaluated and so the judgment of which circuits to interchange does not take those possibilities into account.

A still further alternative design automation approach involves placing an upper bound on the maximum length of a wire within all the nets of the chip design. While automated wire placement is difficult, it is not more difficult to use an upper bound than it is to minimize the wire lengths. This approach evaluates slack as a means to prioritize which nets require special attention by the wiring program. Slack is the difference between the designed (logical) delay and the actual delay (after added wiring delay) from the wiring program. If slack is positive, the net meets the design criteria and does not get additional program attention. If the slack is negative, the net is rerouted until the net slack becomes positive.

Multiprocessor chips are widely used in applications like signal and image processing or logic emulation. For optimum performance on a wide range of applications a flexible low latency communication network between the processors is desired.

### Summary of the invention

The present invention provides for a method of insertion and placement of pipeline latches. The method is performed on the basis of placement data that describes the placement of data sources and data sinks. Preferably each one of the data sources has an assigned set of data sinks to which it needs to communicate along a number of communication paths. The signal propagation along the communication paths is determined by the physical device characteristics; during one clock cycle the signal travels along a communication path for a maximum signal propagation length.

In case a path length is below the maximum signal propagation length the signal can be transmitted from the data source to the corresponding data sink within one clock cycle. In this case no pipeline latch is placed in between the data source and its data sink.

However, if the path length between the data source and its data sink is longer than the maximum signal propagation length one or more pipeline latches are placed between the data source and its data sink along the path connecting the data source and its data sink. The pipeline latches are distanced by distances that are shorter or equal to the maximum signal propagation length. In other words the maximum distance between the data source and the first pipeline latch along the communication path connecting the data source and its data sink is given by the maximum signal propagation length. Likewise the maximum distance between two consecutive pipeline latches a longer path linking the data source and its data sink is given by the maximum signal propagation length.

Preferably the placement of the pipeline latches, if any, is close to the respective boundaries in order to minimize latency times for the transmission of data from data sources to data sinks.

In contrast to the prior art the placement of pipeline latches is performed individually for each data source/data sink pair after physical placement or even wiring of the chip, when goodestimations of the wiring parasitics and timing data are available. This is particularily advantageous for optimization of latch insertion and placement. This way the overall data processing speed can be improved considerably due to optimized latency times for transmission of data from data sources to data sinks. In particular this is advantageous in comparison to latch banks that are replaced by pipeline latches that are placed individually for each data source - data sink connection.

In accordance with a further preferred embodiment of the invention the data sources and/or the data sinks are processors. This way a multiprocessor chip with reduced communication latency times for inter-processor communication is obtained.

In accordance with a further preferred embodiment of the invention the placement of the data sources, the data sinks and the path connecting data sources and data sinks is performed by means of a rectangular grid that defines predetermined positions for placement of data sources, data sinks and paths.

The present invention is particularly advantageous in that it enables to postpone the pipeline insertion until the physical design process when exact placement and timing data are known.

### Brief description of the drawings

In the following preferred embodiments of the invention are explained in greater detail by way of example only by making reference to the drawings in which:
- Figure 1: is a flow diagram illustrating a preferred embodiment of a method of the invention,
- Figure 2: is a highly schematic diagram illustrating the insertion of pipeline latches along a path linking a data source and a data sink,
- Figure 3: is illustrative of a more detailed placement example.

### Detailed description

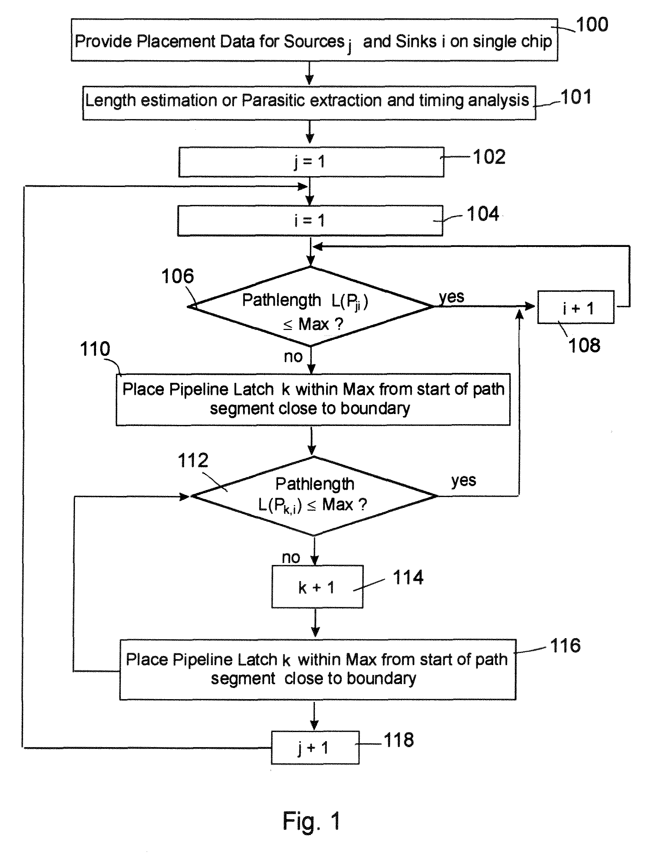

Figure 1 shows a flow chart for performing placement of pipeline latches. In step 100 placement data being descriptive of placement of a number of data sources j and data sinks i on a single chip is provided. The placement can be performed by means of any suitable prior art computer aided placement program. In step 101 either a length estimation or a parasitic extraction and timing analysis procedure is performed.

In steps 102 and 104 the indices j and i are initialized. In step 106 it is determined whether the path length L of the path P_{j,i} linking data source j and data sink i is shorter or equal to the maximum signal propagation length Max.

The maximum signal propagation length Max is the length by which a signal propagates along a communication path on the single chip during one clock cycle. Max can be expressed in length units or time units. For example, when the placement has already been done and time data are available it is advantageous to express Max in terms of arrival time. This is particularily advantageous for timing optimization. The maximum signal propagation length Max can be entered into the program or can be calculated by the program. Preferably the maximum signal propagation length Max is reduced by a safety margin in order to account for physical tolerances that are due to the actual semiconductor fabrication process.

In case the path length L(P_{j,i}) is below or equal Max the control goes to step 108, where the index i is incremented. From there the control goes back to step 106 in order to check the same condition for the next data sink of the set of data sinks that is assigned to data source j.

If the contrary is true the control goes to step 110. In step 110 a first pipeline latch k=1 is placed along the path between data source j and data sink i. The placement starts from the data source j.

Preferably pipeline latch k=1 is placed close to the boundary that is defined by the maximum signal propagation length, i.e. a distance Max from the data source j or a bit closer to data source j if no placement on the maximum signal propagation length is possible due to layout constraints.

In step 112 it is determined whether the remaining path length L from the pipeline latch k=1 to the data sink i is below or equal to the maximum signal propagation length Max. If this is the case the control goes to step 108 as no additional pipeline latch is necessary in the communication path from data source j to data sink i.

If the contrary is true the control goes to step 114 in order to increment k. In step 116 an additional pipeline latch is placed within a maximum distance of Max away from pipeline latch k-1. Preferably pipeline latch k is placed on the boundary that is defined by the distance Max, or - in case this is not possible due to physical design constraints - a bit closer to the pipeline latch k-1. In step 112 the condition L(P k,i) ≤ Max is tested again.

Steps 106 to 116 are performed repeatedly until all paths connecting data source j to its data sinks i have been processed. Next index j is incremented in step 118 and the control goes back to step 104 in order to continue processing for the next data source j. It is to be noted that sinks can also share a common path.

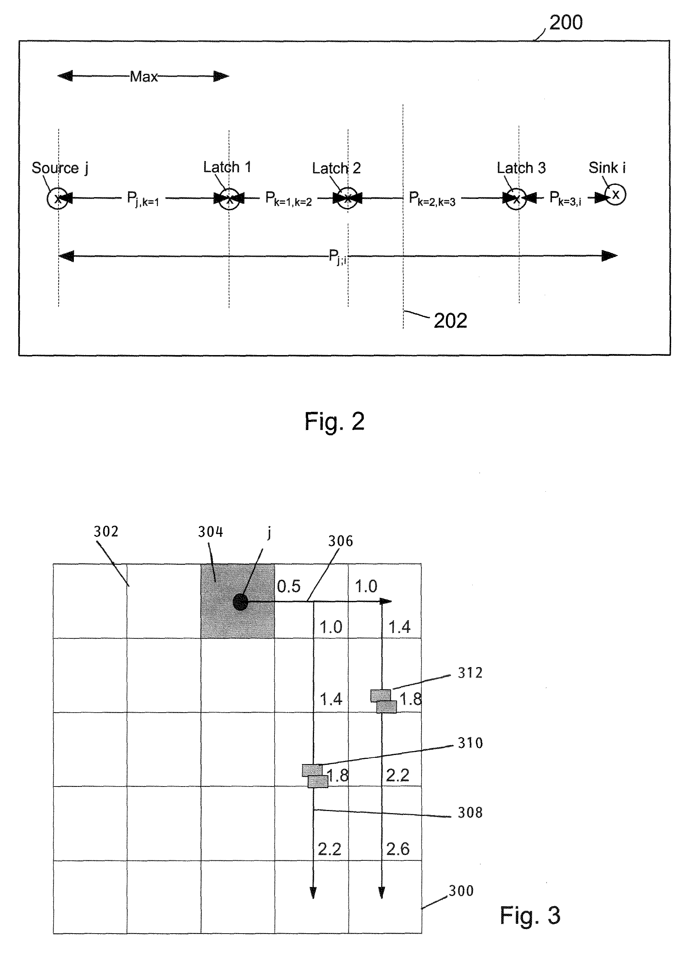

Figure 2 shows integrated circuit chip 200. For ease of explanation only one data source j and one data sink I is shown. Further the maximum signal propagation length Max is illustrated in figure 2.

Data source j and data sink i are connected by a communication path P _{j,i}. The length L (P _{j,i}) is above Max as apparent from figure 2. Hence one or more pipeline latches are required between data source j and data sink i.

The placement procedure starts from data source j. Latch k=1 is placed a distance Max from data source j which provides path segment P j,k=1. As the remaining distance from latch k=1 to data sink i is still above Max one or more additional pipeline latches are required.

In the example considered here it is not possible to place latch 2 on boundary 202, i.e. the distance Max from latch k=1, due to physical constraints of the layout. For example the position where boundary 202 crosses the path P _{j,i} between data source j and data sink i is already occupied by another component.

In this instance latch k=2 is placed a bit closer to latch k=1 which provides path segment P _{k=1,k=2}. The same process is performed in order to place pipeline latch k=3 a distance Max apart from latch k=2. No further pipeline latch is required between latch k=3 and data sink i as the length of the remaining path segment P _{k=3, i} is shorter than Max.

Figure 3 shows chip 300 that is partitioned by rectangular grid 302. Grid 302 defines cells for placement of data sources and data sinks. In the example considered here chip 300 is a multiprocessor chip. In this instance at least some of the cells serve for placement of individual processors. For the purpose of explanation one of the cells i.e. cell 304 is considered in the following.

A processor that provides data source j is placed on cell 304. Data source j is coupled to data sink i (not shown in figure 3) by means of a path comprising wires 306 and 308. It takes 0.5 nanoseconds for a signal to propagate from data source j along wire 306. Wire 308 is delimited by pipeline latch 310. The signal reaches pipeline latch 310 1.8 nanoseconds after it has been output from data source j. This corresponds to a target clock cycle of 2 nanoseconds. Likewise pipeline latch 312 constitutes a first path segment between data source j and another data sink i+1.

It is to be noted that the insertion points for the pipeline latches are unique for each processor. Therefore a detailed list that indicates the data transfers that require one or more additional transfer clock cycles needs to be generated for each data source j.

It needs to be noted that a communication path between data source and data sink can be constituted by simple wiring. Alternatively one or more logic gates, such are inverters, AND, or OR gates can form part of the path.

### LIST OF REFERENCE NUMERALS

- 200: chip
- 202: boundary
- 300: chip
- 302: grid
- 304: cell
- 306: wire
- 308: wire
- 310: pipeline latch
- 312: pipeline latch

## Claims

1. A method for determining placement of pipeline latches, the method comprising:
- providing data descriptive of placement of data sources and data sinks,
- in case a path length of a path connecting one of the data sources to one of the data sinks is longer than a maximum signal propagation length, placing a pipeline latch a distance from the data source, the distance being shorter than or equal to the maximum signal propagation length,
- in case a path length of a path connecting the pipeline latch to the one of the data sinks is longer than the maximum signal propagation length, placing an additional pipeline latch an additional distance from the pipeline latch, the additional distance being shorter than or equal to the maximum signal propagation length.

2. The method of claim 1, the placement of the data sources and the data sinks relating to a single integrated circuit chip.

3. The method of claim 1 or 2, the maximum signal propagation length being the length an output signal of one of the data sources travels along a path from the data source to one of the data sinks during one clock cycle.

4. The method of claim 1, 2 or 3, further comprising providing a rectangular grid for defining potential paths between the data sources and the data sinks.

5. The method of any one of the preceding claims 1 to 4, wherein each one of the data sources has an assigned set of data sinks.

6. A computer program product for determining placement of pipeline latches, the computer program product comprising instructions for:
- reading data descriptive of placement of data sources and data sinks,
- in case a path length of a path connecting one of the data sources to one of the data sinks is longer than a maximum signal propagation length, placing a pipeline latch a distance from the data source, the distance being shorter than or equal to the maximum signal propagation length,
- in case a path length of a path connecting the pipeline latch to the one of the data sinks is longer than the maximum signal propagation length, placing an additional pipeline latch an additional distance from the pipeline latch, the additional distance being shorter than or equal to the maximum signal propagation length.

7. The computer program product of claim 6, the data descriptive of placement of data sources and data sinks relating to a single integrated circuit chip.

8. The computer program product of claim 6 or 7, the instructions being adapted to place the pipeline latches on a rectangular grid.

9. An integrated circuit chip comprising data sources and data sinks, each one of the data sources being connected to at least one of the data sinks by a respective path, wherein paths that are shorter than a maximum signal propagation length have no pipeline latches, and wherein paths that are longer than the maximum signal propagation length have one or more pipeline latches being distanced by distances that are shorter or equal to the maximum signal propagation length.

10. The integrated circuit chip of claim 9, wherein the data sources, the data sinks and the path connecting data sources and data sinks are placed on a rectangular grid.

11. The integrated circuit chip of claim 9 or 10, the data sources being processors.
